# EUROPEAN PATENT APPLICATION

(11) **EP 2 472 594 A1**
(43) Date of publication of application: **04.07.2012**
(21) Application number: 10811587.4
(22) Date of filing: 10.06.2010
(51) Int. Cl.: H01L 31/04

(54) **MULTI-JUNCTION PHOTOELECTRIC CONVERTER, INTEGRATED MULTI-JUNCTION PHOTOELECTRIC CONVERTER, AND METHOD FOR MANUFACTURING SAME**

(30) Priority: 27.08.2009 JP 2009196206
(71) Applicant: National Institute of Advanced Industrial Science and Technology, Tokyo 100-8921 (JP); Mitsubishi Heavy Industries, Ltd., Tokyo 108-8215 (JP)
(72) Inventor: KONDO, Michio, Tsukuba-shi Ibaraki 305-8568 (JP); KOIDA, Takashi, Tsukuba-shi Ibaraki 305-8568 (JP); TAKEUCHI, Yoshiaki, Tokyo 108-8215 (JP); SAKAI, Satoshi, Tokyo 108-8215 (JP); YAMAUCHI, Yasuhiro, Tokyo 108-8215 (JP)
(74) Representative: Henkel, Breuer & Partner
(86) International application number: PCT/JP2010/059857
(87) International publication number: WO 2011/024534

(57) **Abstract**

Disclosed are a multi-junction photoelectric converter and an integrated multi-junction photoelectric converter, having a two-terminal structure, of which layers are laminated under less constraint of the previously laminated layers. Also disclosed is a method for manufacturing such converters. A plurality of photoelectric conversion cells of which spectral sensitivities differ from each other are laminated. At least the photoelectric conversion cells (2, 4) located at a light receiving end and the other end have conductive thin film layers (5a and 5b, 5c and 5d), respectively, on the top layers to be connected thereof. Another photoelectric conversion cell (3) has conductive thin film layers (16a, 16b) at the top and bottom layers, respectively, to be connected thereof. The top and bottom layers are joined to the top and bottom layers of the other cells via anisotropic conductive adhesive layers (6a, 6b) containing conductive fine particles in a transparent insulating material. The conductive fine particles in the anisotropic conductive adhesive layers (6a, 6b) electrically connect the layers in a direction along which the layers are laminated, and the conductive thin film layers (5a, 5b, 5c, 5d) electrically connect the photoelectric conversion layers (2, 3, 4) serving as materials to be joined in lateral directions (in-plane direction).

## Description

### {Technical Field}

The present invention relates to a multi-junction photovoltaic device, an integrated multi-junction photovoltaic device, and processes for producing these devices.

### {Background Art}

In photovoltaic devices used within solar cells that convert the energy from sunlight into electrical energy, the conversion efficiency can be improved by stacking electric power generation layers (photovoltaic layers) having different spectral sensitivity levels to form a multi-junction photovoltaic device. Multi-junction photovoltaic devices include monolithic devices and mechanically stacked devices.

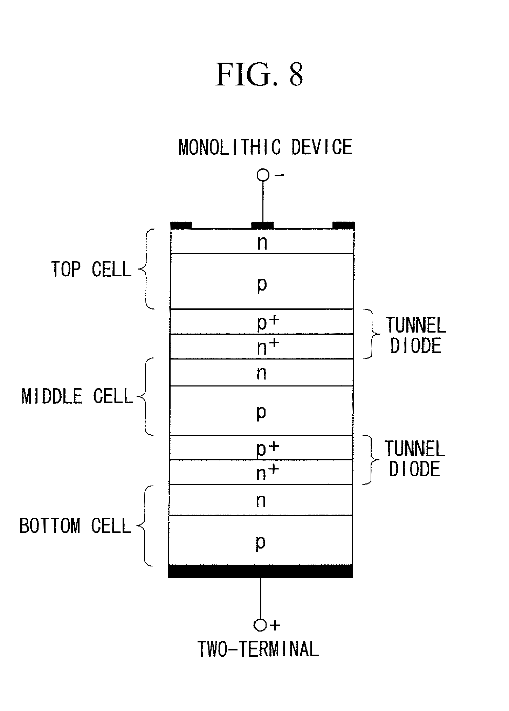

A monolithic photovoltaic device has a two-terminal structure, and is formed using thin-film growth techniques. Fig. 8 illustrates one example of the structure of a monolithic photovoltaic device. In this photovoltaic device, a bottom cell, a tunnel diode, a middle cell, another tunnel diode and a top cell are stacked in order on a + (positive) metal electrode. A - (negative) metal electrode is then provided on top of the top cell. The bottom cell, the middle cell and the top cell each comprises a p-layer and an n-layer stacked in order, with the p-layer closer to the positive electrode. Each of the tunnel diodes comprises an n⁺ layer and a p⁺ layer stacked in order, with the n⁺ layer closer to the positive electrode. Depending on the characteristics of the top cell, the middle cell and the bottom cell, the tunnel diodes may sometimes be unnecessary.

More specific examples of monolithic photovoltaic devices include compound semiconductor solar cells comprising an InGaAs semiconductor layer and an InGaP semiconductor layer formed in that order on a Ge substrate, and silicon-based thin-film solar cells comprising an amorphous silicon semiconductor layer and a microcrystalline silicon semiconductor layer stacked in that order, or in the reverse order, on a glass substrate having a transparent conductive film formed thereon. In the photovoltaic devices mentioned above, the semiconductor layers having a light absorption spectrum toward the short wavelength side, such as the InGaP semiconductor layer and the amorphous silicon semiconductor layer, or semiconductor layers having a broad band gap, absorb mainly light from the short wavelength region, while transmitting light from the long wavelength region. This transmitted long wavelength light is absorbed mainly by the semiconductor layers having a light absorption spectrum toward the long wavelength side, such as the InGaAs semiconductor layer and the microcrystalline silicon semiconductor layer, or semiconductor layers having a narrow band gap. In this manner, by stacking photovoltaic layers having different spectral sensitivity levels, the broad wavelength spectrum of sunlight can be absorbed more efficiently, enabling the production of a photovoltaic device having a higher photovoltaic conversion efficiency. Further, in silicon-based thin-film solar cells, the light confinement effect can be enhanced by forming an appropriate level of asperity on the surface of the transparent conductive film-bearing substrate.

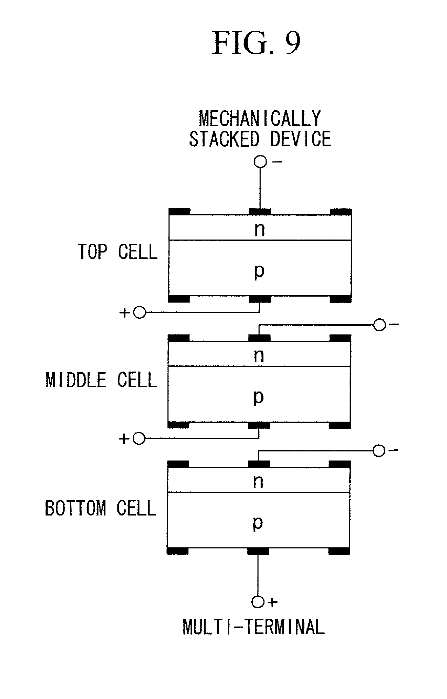

A mechanically stacked photovoltaic device has a multi-terminal structure, and is formed by mechanically bonding two separately formed photovoltaic cells. Fig. 9 illustrates one example of the structure of a mechanically stacked photovoltaic device. In this photovoltaic device, a bottom cell comprising a p-layer, an n-layer and a - (negative) metal electrode stacked in that order on a + (positive) metal electrode, and a middle cell and a top cell having the same structure as the bottom cell are stacked together in that order. A leader line is provided on each of the metal electrodes.

Examples of mechanically stacked photovoltaic devices include the tandem solar cells disclosed in PTL 1, PTL 2 and PTL 3.
The tandem solar cells disclosed in PTL 1 and PTL 2 both have structures in which an upper solar cell element and a lower solar cell element that have been fabricated separately are bonded together with a moisture-proof polymer. The upper solar cell element and the lower solar cell element each have independent structures for extracting the power output. Accordingly, the moisture-proof polymer must be an insulator.
In the tandem solar cell of PTL 1, light from the short wavelength region is absorbed by a chalcopyrite compound cell having a broad band gap, and light from the long wavelength region is absorbed by a monocrystalline silicon cell having a narrow band gap. Overall, the solar cell is able to effectively absorb light across the wavelength spectrum of sunlight, enabling the photovoltaic conversion efficiency of the solar cell to be increased.

In the tandem solar cell of PTL 3, a solar cell element comprising a transparent conductive film, an amorphous silicon film and a transparent conductive film formed on an insulating transparent substrate, and a solar cell element comprising a metal thin film, an amorphous silicon film and a transparent conductive film formed on an insulating substrate are superimposed and bonded together with the transparent conductive films facing each other.

### {Citation List}

### {Patent Literature}

{PTL 1} Japanese Unexamined Patent Application, Publication No. Hei 06-283738 (paragraphs [0008] and [0019])
{PTL 2} Japanese Unexamined Patent Application, Publication No. Hei 07-122762 (paragraphs [0008] and [0013])
{PTL 3} Japanese Unexamined Patent Application, Publication No. Sho 64-41278 (claim 1)

### {Summary of Invention}

### {Technical Problem}

Monolithic multi-junction photovoltaic devices are formed by sequentially stacking each of the layers that constitute the multi-junction photovoltaic device. In a multi-junction photovoltaic device, each layer is generally formed from a different material, with each layer having different physical properties. Accordingly, the physical properties of the previously stacked layer(s) must be considered when stacking the subsequent layers.

For example, in the case where the upper limit for the stable temperature for a previously stacked semiconductor layer is lower than the optimal stacking temperature for a subsequently stacked semiconductor layer, if the subsequently stacked semiconductor layer is stacked at the optimal temperature, then the previously stacked semiconductor layer will degrade. As a result, the stacking conditions for the subsequent layer are limited to conditions that will cause no thermal damage to the underlying layer. However, if the subsequently stacked semiconductor layer is stacked at a temperature lower than the optimal temperature, then the characteristics of that subsequently stacked semiconductor layer tend to deteriorate.

For example, in a compound semiconductor solar cell comprising an InGaP semiconductor layer, an InGaAs semiconductor layer and a Ge substrate, achieving lattice matching of the germanium substrate and the semiconductor layers is given priority. However, this limits the materials that can be used for the semiconductor layers, and it is not possible to select any material having an arbitrary lattice constant and band gap.

For example, in a silicon-based thin-film solar cell comprising a transparent conductive film-bearing substrate, an amorphous silicon semiconductor layer, and a microcrystalline silicon semiconductor layer, there are no lattice matching restrictions. However, because the range of light wavelengths absorbed differs between the amorphous silicon semiconductor layer and the microcrystalline silicon semiconductor layer, the optimal shape for the asperity that should be formed on the surface of the transparent conductive film-bearing substrate also differs.
In order to ensure confinement of light from the long wavelength region, the asperity is preferably larger. On the other hand, the asperity on the surface of the transparent conductive film-bearing substrate has an intermediate refractive action, which has the effect of suppressing interface reflection caused by refractive index difference. Accordingly, if the asperity is large, then light from the short wavelength region tends to be reflected. Further, a large asperity has also been shown to increase light confinement and loss within the transparent conductive film.

In order to address the problems described above, transparent conductive film-bearing substrates have been developed with a dual texture structure that exhibits light confinement effects for light from both the short wavelength region and the long wavelength region. However, in order to enable a silicon semiconductor layer to be formed with good adhesion on such a dual texture structure having a special shape, the deposition process conditions must be limited, meaning achieving deposition of high-quality silicon semiconductor layers is difficult.

In contrast, in the case of a mechanically stacked photovoltaic device, because the two photovoltaic cells are formed separately, each photovoltaic cell may be formed under different conditions. In other words, issues such as the possibility of thermal damage to the lower photovoltaic cell during stacking of the upper photovoltaic cell, which are a concern in monolithic devices, need not be considered, meaning the optimal conditions can be selected for the formation of each respective photovoltaic cell. However, in the photovoltaic devices disclosed in PTL 1 and PTL 2, the separate photovoltaic cells are bonded together mechanically using an insulating transparent epoxy resin, and there is no electrical connection between the photovoltaic cells. As a result, the electrode of each cell must be extracted externally from the bonded portion, resulting in a multi-terminal structure. In a photovoltaic device having this type of multi-terminal structure, if the surface area of the photovoltaic cells is large, then the distance over which the electrode must be extracted from the central section of the photovoltaic cell becomes quite long, resulting in increased electrical resistance and greater power loss. Further, space must be provided within the structure for extracting the electrodes externally and connecting the electrodes, resulting in an increase in the size of the element.

In the mechanically stacked photovoltaic device disclosed in Patent Document 3, the transparent conductive films are bonded tightly together, enabling optical and electrical connection. However, a problem arises in that in order to increase the mechanical bonding strength, the degree of freedom in terms of structural factors such as the variety of transparent conductive films that can be bonded, and the smoothness of the transparent conductive film is extremely limited. As a result, photovoltaic cells having surface asperity that is generated naturally during production, or photovoltaic cells having a textured structure provided with specific asperity designed to contain light within the semiconductor layer, cannot be mechanically stacked.

The present invention has been developed in light of the above circumstances, and has an object of providing a multi-junction photovoltaic device and an integrated multi-junction photovoltaic device having a two-terminal structure, in which subsequent layers can be stacked under conditions with minimal restrictions imposed by previously stacked layers, as well as providing processes for producing these devices.

### {Solution to Problem}

A first aspect of the present invention provides a multi-junction photovoltaic device prepared by stacking, and optically and electrically connecting, a plurality of photovoltaic cells having different spectral sensitivity levels, wherein at least the photovoltaic cells at the light-incident end and the opposite end have a conductive thin-film layer as the outermost layer on the side that undergoes connection, the remaining photovoltaic cells have conductive thin-film layers as the outermost layers on both sides that undergo connection, and the outermost layers are bonded via an anisotropic conductive adhesive layer containing conductive microparticles within a transparent insulating material.

According to the first aspect, because the plurality of different photovoltaic cells are formed on a plurality of different substrates, the ideal substrate and deposition conditions can be selected for each photovoltaic cell. Further, in the first aspect, because a plurality of photovoltaic cells having different spectral sensitivity levels are stacked and bonded together, the broad wavelength spectrum of sunlight can be absorbed effectively, enabling the photovoltaic conversion efficiency of the multi-junction photovoltaic device to be increased.

Furthermore, in the first aspect, because the bonding sections of each of the photovoltaic cells are bonded together via the anisotropic conductive adhesive layers containing conductive microparticles (dispersed) within a transparent insulating material, the mechanical, electrical and optical connections between the photovoltaic cells are achieved simultaneously. Accordingly, with the exception of the photovoltaic cells at the two ends of the device, the electrodes of the other photovoltaic cells need not be extracted externally, meaning the electrical resistance can be reduced, power loss can be reduced, and the surface area of the element can also be reduced.

In the first aspect described above, the number of photovoltaic cells may be two.

A second aspect of the present invention provides a multi-junction photovoltaic device comprising an upper photovoltaic cell having a transparent electrode layer, an upper photovoltaic layer and an upper conductive thin-film layer provided in that order on an upper transparent substrate, a lower photovoltaic cell having a back electrode layer, a lower photovoltaic layer having a different spectral sensitivity from the upper photovoltaic layer, and a lower conductive thin-film layer provided in that order on a lower substrate, and an anisotropic conductive adhesive layer comprising a transparent insulating material having an adhesive function and conductive microparticles dispersed within the transparent insulating material, wherein the upper conductive thin-film layer is positioned adjacent to one surface of the anisotropic conductive adhesive layer, the lower conductive thin-film layer is positioned adjacent to the other surface of the anisotropic conductive adhesive layer, and the upper photovoltaic cell and the lower photovoltaic cell are connected electrically in series via the anisotropic conductive adhesive layer.

According to the second aspect, because the spectral sensitivity levels of the upper photovoltaic cell and the lower photovoltaic cell differ, a photovoltaic device is obtained that can absorb light across a broad wavelength region. The upper photovoltaic cell and the lower photovoltaic cell can be produced using deposition processes appropriate for each photovoltaic cell. Accordingly, there is no danger of a deterioration in performance caused by thermal damage to the lower photovoltaic cell during the production of the upper photovoltaic cell, which can be a concern in monolithic multi-junction photovoltaic devices. The transparent insulating material contained within the anisotropic conductive adhesive layer exhibits good light transmission and adhesive properties. Further, the transparent insulating material ensures that the anisotropic conductive adhesive layer retains insulating properties in the in-plane direction. The conductive microparticles dispersed within the transparent insulating material impart conductivity to the anisotropic conductive adhesive layer in the thickness direction, and perform the role of electrically connecting the upper photovoltaic cell and the lower photovoltaic cell. As a result, a multi-junction photovoltaic device having a two-terminal structure can be achieved, and an output is not required for each photovoltaic cell. The conductive thin-film layers positioned between each of the photovoltaic cells and the anisotropic conductive adhesive layer perform the role of maintaining conductivity in the in-plane direction.

In the second aspect, the anisotropic conductive adhesive layer preferably exhibits a light transmittance of at least 80% for light of the wavelength region absorbed mainly by the lower photovoltaic layer. Further, the refractive index of the anisotropic conductive adhesive layer is preferably not less than 1.2 and not more than 2.0. Ensuring such a refractive index ensures an appropriate amount of light for use within the lower photovoltaic cell.

In the second aspect, the upper photovoltaic layer preferably comprises mainly amorphous silicon, the transparent electrode layer preferably has a textured structure on the surface on the opposite side from the upper transparent substrate, and the textured structure preferably has asperity with a pitch and height of not less than 0.1 µm and not more than 0.3 µm. This enables a superior light confinement effect to be achieved for the wavelengths mainly absorbed by the upper photovoltaic layer comprising mainly amorphous silicon.

In the second aspect, the lower photovoltaic layer preferably comprises mainly microcrystalline silicon, the back electrode layer preferably has a textured structure on the surface on the opposite side from the lower substrate, and the textured structure preferably has asperity with a pitch and height of not less than 0.3 µm and not more than 1.0 µm. This enables a superior light confinement effect to be achieved for the wavelengths mainly absorbed by the lower photovoltaic layer comprising mainly microcrystalline silicon.

In the first or second aspect described above, the conductive thin-film layers serve a role in achieving electrical connection in a lateral direction within the photovoltaic layer of each single cell, as well as a role in reducing the contact interface resistance with the anisotropic conductive adhesive layer. Accordingly, the conductive thin-film layer is preferably at least one of an impurity-doped low-resistance semiconductor layer and a grid electrode layer is preferred. Further, the impurity-doped low-resistance semiconductor layer may be a low-resistance transparent conductive layer with a similarly low resistance.

A third aspect of the present invention provides a process for producing a multi-junction photovoltaic device, the process comprising a step of forming a first conductive thin-film layer on a first semiconductor, a step of forming a second conductive thin-film layer on a second semiconductor, and a step of inserting an anisotropic conductive adhesive layer comprising conductive microparticles dispersed within a transparent insulating material between the first conductive thin-film layer and the second conductive thin-film layer, and bonding a first integrated photovoltaic device and a second integrated photovoltaic device via the anisotropic conductive adhesive layer.

According to the third aspect, a multi-junction photovoltaic device can be produced without worrying about the types of issues that are a concern in monolithic multi-junction photovoltaic devices, such as the possibility of a deterioration in performance caused by thermal damage to a previously formed photovoltaic cell during a step of producing a subsequently stacked photovoltaic cell.

A fourth aspect of the present invention provides a process for producing a multi-junction photovoltaic device, the process comprising a step of forming an upper photovoltaic cell having a transparent electrode layer, an upper photovoltaic layer and an upper conductive thin-film layer provided in that order on an upper transparent substrate, a step of forming a lower photovoltaic cell having a back electrode layer, a lower photovoltaic layer having a different spectral sensitivity from the upper photovoltaic layer, and a lower conductive thin-film layer provided in that order on a lower substrate, a step of forming a stacked structure by positioning the upper photovoltaic cell, an anisotropic conductive adhesive layer comprising a transparent insulating material having an adhesive function and conductive microparticles dispersed within the transparent insulating material, and the lower photovoltaic cell so that the upper conductive thin-film layer is positioned adjacent to one surface of the anisotropic conductive adhesive layer and the lower conductive thin-film layer is positioned adjacent to the other surface of the anisotropic conductive adhesive layer, and a step of subjecting the stacked structure to thermocompression bonding to bond together the upper photovoltaic cell, the anisotropic conductive adhesive layer and the lower photovoltaic cell.

According to the fourth aspect, a multi-junction photovoltaic device can be produced without worrying about the types of issues that are a concern in monolithic multi-junction photovoltaic devices, such as the possibility of a deterioration in performance caused by thermal damage to the lower photovoltaic cell during the step of forming the upper photovoltaic cell.

In the fourth aspect, the anisotropic conductive adhesive layer may also be formed using any one of an anisotropic conductive adhesive sheet, a polymer adhesive containing dispersed metal particles, and mixed microparticles composed of polymer microparticles and conductive microparticles.
Because an anisotropic conductive adhesive sheet is a cured adhesive sheet, handling is simplified. On the other hand, a polymer adhesive containing dispersed metal particles exhibits good fluidity. Accordingly, the thickness of the anisotropic conductive adhesive layer can be readily adjusted. Moreover, the upper photovoltaic cell and the lower photovoltaic cell can be bonded together using a lower pressure than that required with a cured adhesive sheet. As a result, any deterioration in yield due to damage caused by excessive pressure application during actual production can be prevented.
Mixed microparticles composed of polymer microparticles and conductive microparticles enable the formation of a thinner anisotropic conductive adhesive layer that that formed when either an anisotropic conductive adhesive sheet or a polymer adhesive containing dispersed metal particles is used. Further, the mixed microparticles can form voids within the anisotropic conductive adhesive layer. As a result, an anisotropic conductive adhesive layer having superior light transmittance and a low refractive index can be formed.

A fifth aspect of the present invention provides an integrated multi-junction photovoltaic device prepared by stacking, and optically and electrically connecting, two photovoltaic cells having different spectral sensitivity levels, wherein each of the integrated photovoltaic devices has a conductive thin-film layer as an outermost layer on the side that undergoes connection, and the outermost layers, and electrodes on the opposite side that function as the counter electrode to the outermost layers, are bonded via an anisotropic conductive adhesive layer comprising conductive microparticles within a transparent insulating material, thereby connecting adjacent multi-junction photovoltaic elements in series.

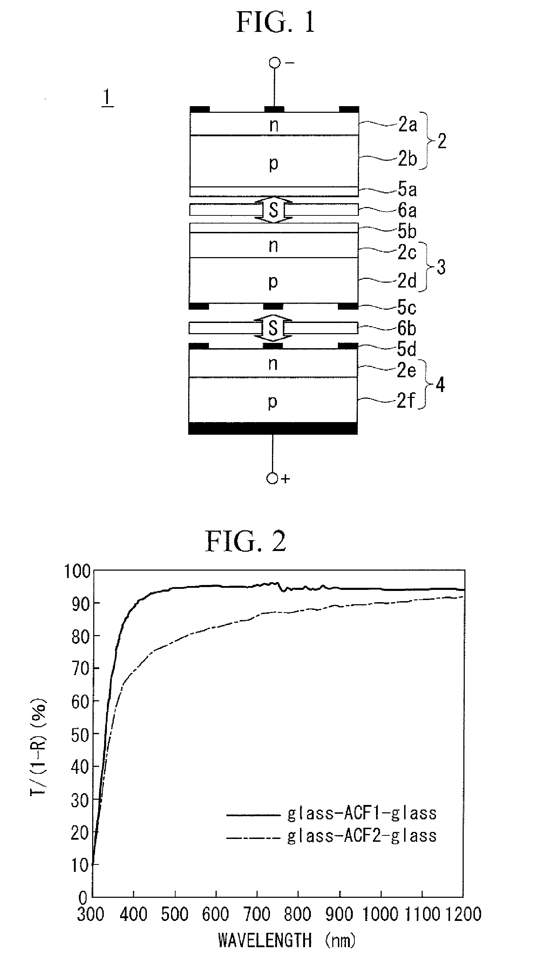

According to the fifth aspect, an integrated multi-junction photovoltaic device is obtained that combines a two-terminal structure with a mechanically stacked structure, such as the structure illustrated in Fig. 1. Specifically, an integrated multi-junction photovoltaic device is obtained in which different solar cells are bonded together mechanically, electrically and optically via the conductive thin-film layers (such as impurity-doped low-resistance semiconductor layers or grid electrode layers) and the anisotropic conductive adhesive layer.

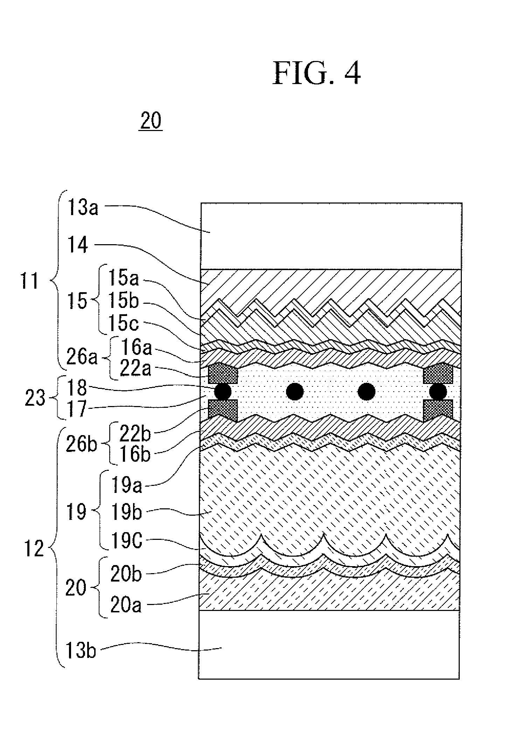

By depositing conductive thin-film layers (impurity-doped low-resistance semiconductor layers or grid electrode layers) on the surfaces of the materials to be bonded, inserting the anisotropic conductive adhesive layer between the materials to be bonded, and then performing thermocompression bonding, the two materials are bonded together. The conductive particles within the anisotropic conductive adhesive layer effect electrical connection of the two layers in the stacking direction. The conductive thin-film layers (impurity-doped low-resistance semiconductor layers or grid electrode layers) effect electrical connection in the lateral direction (in-plane direction) within each of the photovoltaic layers that represent the bonded layers. Further, as illustrated in Fig. 4, a mechanically stacked solar cell module in which the photovoltaic modules are mechanically stacked may be formed.

In the integrated multi-junction photovoltaic device according to the fifth aspect, the bonding sections of each of the integrated photovoltaic devices are bonded together via the scattered anisotropic conductive adhesive layer containing conductive microparticles within a transparent insulating material. As a result, connection can be achieved between the outermost layers on the sides of each of the integrated photovoltaic devices that are to be connected, and connection can also be achieved between the electrodes at the opposite sides, which function as the opposing electrodes to the electrodes of the outermost layers. At the same time, electrical insulation of the two bonding sections is still maintained, meaning the adjacent multi-junction photovoltaic devices can be connected in series. Each of the integrated solar cells can be produced under the respective optimal conditions, and a multi-junction device can then be obtained. As a result, compared with monolithic integrated multi-junction photovoltaic devices, the possibility of a deterioration in performance caused by thermal damage to the lower solar cell during the production process for the upper solar cell, or the possibility of a deterioration in the yield during the integration process can be avoided. In other words, an integrated multi-junction photovoltaic device having improved performance can be produced with superior yield.

A sixth aspect of the present invention provides an integrated multi-junction photovoltaic device, comprising an upper photovoltaic module formed from integrated upper photovoltaic cells having a transparent electrode layer, and an upper power generation portion and an upper conductive portion disposed so as to be isolated from the upper power generation portion provided on top of the transparent electrode layer, and provided with an upper conductive thin-film layer positioned as the outermost surface layer on the upper power generation portion and the upper conductive portion, a lower photovoltaic module formed from integrated lower photovoltaic cells having a back electrode layer, and a lower power generation portion having a different spectral sensitivity from the upper powder generation portion and a lower conductive portion disposed so as to be isolated from the lower power generation portion provided on top of the back electrode layer, and provided with a lower conductive thin-film layer positioned as the outermost surface layer on the lower power generation portion and the lower conductive portion, and an anisotropic conductive adhesive layer comprising a transparent insulating material and conductive microparticles dispersed within the transparent insulating material, wherein the upper conductive thin-film layer is positioned adjacent to one surface of the anisotropic conductive adhesive layer, the lower conductive thin-film layer is positioned adjacent to the other surface of the anisotropic conductive adhesive layer, the upper power generation portion of a predetermined upper photovoltaic cell and the lower power generation portion of a predetermined lower photovoltaic cell are aligned, and the lower conductive portion of a predetermined lower photovoltaic cell is aligned with the upper conductive portion of an upper photovoltaic cell adjacent to a predetermined upper photovoltaic cell, the aligned upper power generation portion and lower power generation portion are connected electrically in series via the anisotropic conductive adhesive layer, and the aligned upper conductive portion and lower conductive portion are connected electrically via the anisotropic conductive adhesive layer.

According to the sixth aspect, the upper photovoltaic module and the lower photovoltaic module are bonded together via the anisotropic conductive adhesive layer. The upper photovoltaic cells and lower photovoltaic cells become multi-junction photovoltaic cells that are connected electrically in series via the anisotropic conductive adhesive layer. The upper conductive portion and the lower conductive portion function as conductive members that electrically connect the transparent electrode layer and the back electrode layer in series via the anisotropic conductive adhesive layer. Accordingly, an integrated multi-junction photovoltaic device is obtained in which adjacent multi-junction photovoltaic cells are connected electrically in series by the above conductive members. Because the anisotropic conductive adhesive layer exhibits insulating properties in the in-plane direction, there is no need to be concerned about current leakage between adjacent photovoltaic cells.

A seventh aspect of the present invention provides a process for producing an integrated multi-junction photovoltaic device, the process comprising a step of producing an upper photovoltaic module by integrating upper photovoltaic cells having a transparent electrode layer, an upper power generation portion and an upper conductive portion isolated from the upper power generation portion provided on top of the transparent electrode layer, and an upper conductive thin-film layer provided as the outermost surface layer on the upper power generation portion and the upper conductive portion, a step of producing a lower photovoltaic module by integrating lower photovoltaic cells having a back electrode layer, a lower power generation portion and a lower conductive portion isolated from the lower power generation portion provided on top of the back electrode layer, and a lower conductive thin-film layer provided as the outermost surface layer on the lower power generation portion and the lower conductive portion, a step of forming a stacked structure by positioning the upper photovoltaic module, an anisotropic conductive adhesive layer comprising a transparent insulating material having an adhesive function, and conductive microparticles dispersed within the transparent insulating material, and the lower photovoltaic module so that the upper conductive thin-film layer is positioned adjacent to one surface of the anisotropic conductive adhesive layer, the lower conductive thin-film layer is positioned adjacent to the other surface of the anisotropic conductive adhesive layer, the upper power generation portion of a predetermined upper photovoltaic cell and the lower power generation portion of a predetermined lower photovoltaic cell are aligned, and the lower conductive portion of a predetermined lower photovoltaic cell is aligned with the upper conductive portion of an upper photovoltaic cell adjacent to a predetermined upper photovoltaic cell, and a step of subjecting the stacked structure to thermocompression bonding, thereby bonding together the upper photovoltaic cell, the anisotropic conductive adhesive layer and the lower photovoltaic cell, and the upper conductive portion, the anisotropic conductive adhesive layer and the lower conductive portion.

According to the seventh aspect, an integrated multi-junction photovoltaic device can be produced from photovoltaic modules having different spectral sensitivity levels.

### {Advantageous Effects of Invention}

According to the present invention, photovoltaic layer materials can be selected with minimal restrictions in terms of lattice mismatching or production temperature. Further, a multi-junction photovoltaic device and an integrated multi-junction photovoltaic device having a two-terminal structure can be provided in which subsequent layers can be stacked with minimal restrictions imposed by the physical properties of previously stacked layers.

### {Brief Description of Drawings}

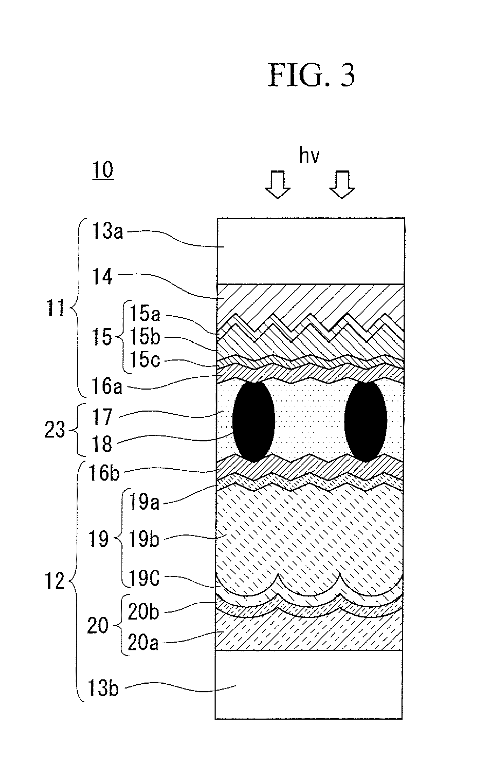

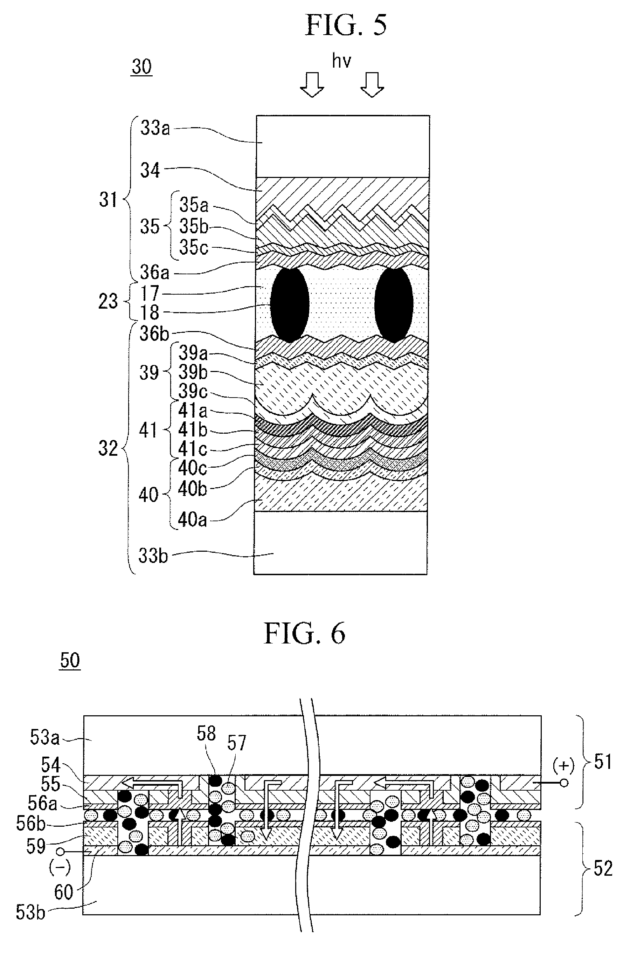

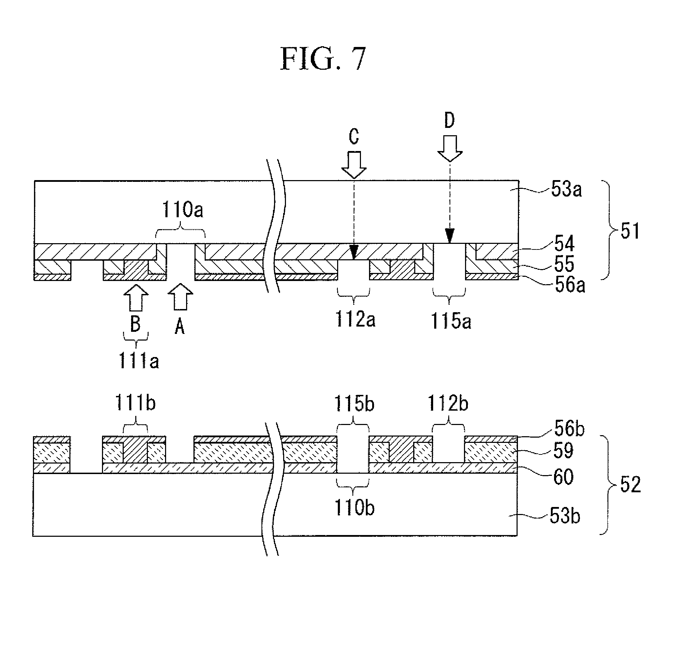

{Fig. 1} A schematic view illustrating the structure of a photovoltaic device 1 according to a first embodiment.
{Fig. 2} A graph illustrating the light transmission characteristics of alkali-free glass/ACF/alkali-free glass structures.
{Fig. 3} A schematic view illustrating the structure of a multi-junction photovoltaic device 10 according to a second embodiment.
{Fig. 4} A schematic view illustrating the structure of a multi-junction photovoltaic device 20 according to a fifth embodiment.
{Fig. 5} A schematic view illustrating the structure of a photovoltaic device 30 according to a sixth embodiment.
{Fig. 6} A schematic view illustrating the structure of a photovoltaic device 40 according to a seventh embodiment.
{Fig. 7} A diagram describing a process for producing the photovoltaic device 40 according to the seventh embodiment.
{Fig. 8} A schematic view illustrating the structure of a conventional multi-junction photovoltaic device.
{Fig. 9} A schematic view illustrating the structure of a conventional multi-junction photovoltaic device.

### {Description of Embodiments}

A feature of a multi-junction photovoltaic device and an integrated multi-junction photovoltaic device according to the present invention is the fact that two or more photovoltaic cells having different spectral sensitivity levels are connected optically and electrically in series via an anisotropic conductive adhesive layer.

Embodiments of the multi-junction photovoltaic device according to the present invention are described below with reference to the drawings.

### [First Embodiment]

Fig. 1 is a schematic view illustrating the structure of a photovoltaic device 1 according to the first embodiment.
A photovoltaic device 1 comprises a pn junction cell 2, a pn junction cell 3, a pn junction cell 4, a conductive semiconductor layer 5, and an anisotropic conductive adhesive layer 6. Further, the photovoltaic device 1 has a two-terminal structure.

The pn junction cell 2 functions as the top cell, and comprises a p-layer 2b and an n-layer 2a. The pn junction cell 3 functions as the middle cell, and comprises a p-layer 2d and an n-layer 2c. The pn junction cell 4 functions as the bottom cell, and comprises a p-layer 2f and an n-layer 2e. These three pn junction cells are photovoltaic layers that correspond with the top cell, the middle cell and the bottom cell respectively within the mechanically stacked solar cell illustrated in Fig. 5(b).
The pn junction cells may be formed as different solar cells, and may also adopt a pin structure. nip structures and np structures in which the order of the p-type semiconductor layer and the n-type semiconductor layer is reversed are also possible.

When stacking the pn junction cell 2, the pn junction cell 3 and the pn junction cell 4, conductive thin-film layers 5 are provided on the opposing surfaces of each pair of adjacent pn junction cells. The conductive thin-film layers 5 have conductivity, and effect electrical connection in the lateral direction (in-plane direction) across the photovoltaic layers. As illustrated in Fig. 1, the conductive thin-film layers 5 are composed of an impurity-doped low-resistance semiconductor layer 5a, an impurity-doped low-resistance semiconductor layer 5b, a grid electrode layer 5c, and a grid electrode layer 5d. In this embodiment, an impurity-doped low-resistance semiconductor layer describes a semiconductor of the same variety as the photovoltaic layer that has been doped with an excess of an impurity, but a transparent conductive film layer having a similarly low resistance may also be used.

One anisotropic conductive adhesive layer 6a is positioned between the impurity-doped low-resistance semiconductor layer 5a and the impurity-doped low-resistance semiconductor layer 5b. One anisotropic conductive adhesive layer 6b is positioned between the grid electrode layer 5c and the grid electrode layer 5d.

In the present embodiment, the opposing pairs of conductive thin-film layers 5 are a pair of impurity-doped low-resistance semiconductor layers and a pair of grid electrode layers, but combinations of an impurity-doped low-resistance semiconductor layer and a grid electrode layer are also possible. Further, a two-layer structure in which a grid electrode layer is provided on top of an impurity-doped low-resistance semiconductor layer may also be adopted as a single layer structure. In other words, the structures of the conductive thin-film layers 5 that sandwich the anisotropic conductive adhesive layer 6 therebetween may comprise any arbitrary combination of (i) an impurity-doped low-resistance semiconductor layer, (ii) a grid electrode layer, and (iii) a two-layer structure having a grid electrode layer provided on top of an impurity-doped low-resistance semiconductor layer.

The anisotropic conductive adhesive layers 6 (in this embodiment, the anisotropic conductive adhesive layer 6a and the anisotropic conductive adhesive layer 6b) have anisotropy that causes an electric current to flow mainly in the stacking direction. In the present embodiment, the anisotropic conductive adhesive layers 6 possess an electrical connection function in the thickness direction via the conductive microparticles, but possess an insulating function in a direction perpendicular to the thickness direction.

The anisotropic conductive adhesive layers 6 are composed of a material prepared by dispersing conductive microparticles within a transparent insulating material. The transparent insulating material is an insulating material that exhibits superior transparency. The transparent insulating material also exhibits a function of bonding to other members when heated and placed under pressure.

Examples of materials that may be used as the transparent insulating material include organic materials such as epoxy adhesives and acrylic adhesives. An inorganic material that exhibits the properties described above may also be used as the transparent insulating material. The term "transparent" in the expression "transparent insulating material" refers to transparency relative to light of wavelengths within the spectral sensitivity region of the photovoltaic cell positioned on the opposite side of the anisotropic conductive adhesive layer 6 from the light-incident side, and is not limited to transparency in the visible region.

The conductive microparticles are particles that can be combined with the transparent insulating material and have the function of electrically connecting the stacked photovoltaic cells of different spectral sensitivity levels.
Examples of the conductive microparticles include solder balls with a diameter of 1 µm to 50 µm, microparticles of copper, nickel (for example, nickel fiber ACF, manufactured by Btech Corporation), graphite, silver, aluminum, tin, gold or platinum, alloy microparticles composed of a plurality of different metals (such as those available from Hitachi Chemical Co., Ltd.), microparticles of polystyrene or acrylic coated with a metal thin film of gold or nickel (such as those available from Sony Chemical & Information Device Corporation), microparticles of conductive oxides and microparticles of conductive semiconductors. The conductive microparticles preferably exhibit elasticity.

The particle size and density of the conductive microparticles within the transparent insulating material may be set appropriately, provided that the conductivity of the anisotropic conductive adhesive layer 6 in the thickness direction is satisfactory, namely provided that there is essentially no resistance loss between the photovoltaic cells.

Further, the particle size and density of the conductive microparticles within the transparent insulating material are preferably set with due consideration of the light transmittance of the anisotropic conductive adhesive layer 6. For example, in order to suppress optical loss due to the conductive microparticles, the particle size of the conductive microparticles is preferably no greater than the wavelength of the light mainly absorbed by the photovoltaic cell positioned in the location that utilizes the light transmitted through the anisotropic conductive adhesive layer 6. Examples of the light transmission characteristics of the anisotropic conductive adhesive layer 6 for different conductive microparticle densities are described below. In these examples, stacked structures were prepared by sandwiching an anisotropic conductive adhesive sheet (ACF, thickness: 15 µm) that used a nickel alloy as the conductive microparticles (particle size: approximately 10 µm) between two sheets of alkali-free glass (thickness: 1.1 mm, manufactured by Corning Incorporated). For the anisotropic conductive adhesive sheet, either a sheet ACF1 containing 5% by weight of the nickel alloy particles within an epoxy resin, or a sheet ACT2 containing 10% by weight of the nickel alloy particles within an epoxy resin was used.
Fig. 2 illustrates the light transmission characteristics of the alkali-free glass/ACF/alkali-free glass structures. In the figure, the horizontal axis represents the wavelength, and the vertical axis represents the light transmittance [Transmittance (T) / (1 - reflectance (R)]. Fig. 2 reveals that the light transmittance of the stacked structure varied depending on the amount of the conductive microparticles.

In the present embodiment, the anisotropic conductive adhesive layers 6 are formed using an anisotropic conductive adhesive. An organic material obtained by curing an epoxy adhesive or an acrylic resin adhesive containing not more than 30% by weight of conductive microparticles is used as the anisotropic conductive adhesive.

The stacked structure having each of the layers stacked as illustrated in Fig. 1 is subjected to overall heating, while pressure is applied so as to compress the regions indicated by the arrows in the figure (namely, the interfaces between the conductive thin-film layer 5a, the anisotropic conductive adhesive layer 6a and the conductive thin-film layer 5b, and the interfaces between the grid electrode layer 5c, the anisotropic conductive adhesive layer 6b and the grid electrode layer 5d) in a compression direction (the direction indicated by the bonding arrows s). This bonds s each of the pn junction cells together.

The photovoltaic device 1 according to the present embodiment is produced by depositing a conductive thin-film layer 5 on at least one surface of each of the different photovoltaic cells that function as the materials to be bonded, inserting an anisotropic conductive adhesive layer 6 between the materials to be bonded, and subjecting the resulting structure to thermocompression bonding. In this type of photovoltaic device, the different photovoltaic cells are bonded together mechanically, electrically and optically by the conductive thin-film layers 5 and the anisotropic conductive adhesive layers 6.
By bonding different photovoltaic cells using the anisotropic conductive adhesive layers 6, mechanically stacked solar cell devices comprising mechanically stacked solar cell modules can also be produced, as shown below in Fig. 6.
In this embodiment, the multi-junction photovoltaic device included three stages, but any number of stages may be employed by altering the positioning of the electrodes.

### [Second Embodiment]

A multi-junction photovoltaic device according to the second embodiment is a silicon-based solar cell comprising an upper photovoltaic cell, an anisotropic conductive adhesive layer, and a lower photovoltaic cell stacked together.
Here, the term "silicon-based" is a generic term that includes silicon (Si), silicon carbide (SiC) and silicon germanium (SiGe). (Further, the term "crystalline silicon-based" describes a silicon system other than an amorphous silicon system, and includes both microcrystalline silicon systems and polycrystalline silicon systems.)

Fig. 3 is a schematic view illustrating the structure of a multi-junction photovoltaic device 10 according to the second embodiment. In this embodiment, an upper photovoltaic cell 11 is positioned on the light-incident side of an anisotropic conductive adhesive layer 23, and a lower photovoltaic cell 12 is positioned on the opposite side of the anisotropic conductive adhesive layer 23 from the upper photovoltaic cell 11.

An example of a process for producing the multi-junction photovoltaic device 10 according to the present embodiment is described below.

### (Upper Photovoltaic Cell)

In the present embodiment, the upper photovoltaic cell 11 is a superstrate-type hydrogenated amorphous silicon thin-film solar cell element comprising a substrate 13a, a transparent electrode layer 14, an amorphous silicon photovoltaic layer 15, and a conductive thin-film layer 16a.

The substrate 13a is a member having superior light transmission characteristics. For example, the substrate 13a may be a sheet of glass or a transparent film or the like. In the present embodiment, an alkali-free glass (manufactured by Corning Incorporated) is used as the substrate 13a.
The transparent electrode layer 14 is formed on the substrate 13a. In the step of forming the transparent electrode layer 14, a magnetron sputtering method is first used to deposit a thin film of aluminum (Al)-doped zinc oxide (ZnO) with a thickness of 1,000 nm on the substrate 13a. The magnetron sputtering conditions include a temperature of 350°C and a target of ZnO comprising 1% by weight of Al₂O₃. Subsequently, the deposited thin film of Al-doped ZnO (AZO) is etched within an aqueous solution of hydrochloric acid to form an appropriate texture on the surface of the AZO thin film on the opposite side from the substrate 13a. This reduces the average thickness of the transparent electrode layer 14 to approximately 500 nm.

The textured structure formed on the surface of the transparent electrode layer 14 preferably has sub-micron size asperity in which the height and pitch are both not less than 0.1 µm and not more than 0.3 µm. This size ensures that the asperity is appropriate for confinement of light within the wavelength region utilized by the amorphous silicon.

The transparent electrode layer 14 is not limited to an AZO thin film, and a thin film of Ga-doped ZnO (GZO) formed using a similar method to the AZO thin film may also be used.
Further, the method used for forming the textured structure on the surface of the transparent electrode layer 14 is not limited to etching with hydrochloric acid, and any method that is capable of forming the desired textured structure may be used. For example, plasma etching or the like may also be used.

Next, using a plasma-enhanced chemical vapor deposition method, the amorphous silicon photovoltaic layer 15 is formed on the transparent electrode layer 14 at a substrate temperature of 180°C. The amorphous silicon photovoltaic layer 15 is formed by sequentially depositing a p-type amorphous silicon layer 15a having a thickness of 30 nm, an i-type (undoped) amorphous silicon layer 15b having a thickness of 200 nm, and an n-type amorphous silicon layer 15c having a thickness of 30 nm.

Subsequently, the conductive thin-film layer 16a is formed on the amorphous silicon photovoltaic layer 15. In the present embodiment, the conductive thin-film layer 16a is an impurity-doped low-resistance semiconductor layer. The impurity-doped low-resistance semiconductor layer is used as a transparent conductive layer. Specifically, a magnetron sputtering method is used without heating to deposit a thin film of indium tin oxide (ITO) comprising 10% by weight of SnO₂ with a thickness of 20 nm. A Ga- or Al-doped ZnO (GZO, AZO) thin film or the like may also be used as the conductive thin-film layer 16a.

### (Lower Photovoltaic Cell)

In the present embodiment, the lower photovoltaic cell is a substrate-type microcrystalline silicon solar cell element comprising a substrate 13b, a back electrode layer 20, a microcrystalline silicon photovoltaic layer 19, and a conductive thin-film layer 16b.

A metal substrate or a glass substrate or the like may be used as the substrate 13b of the lower photovoltaic cell 12. In this embodiment, an alkali-free glass (manufactured by Corning Incorporated) is used.
The back electrode layer 20 preferably has a high reflectance. In the present embodiment, the back electrode layer 20 is formed from a thin film of silver (Ag) and a thin film of GZO. First, an Ag thin film 20a having a thickness of 100 nm is deposited on the substrate 13b by magnetron sputtering with no heating. Subsequently, using a target of ZnO comprising 5.7% by weight of Ga₂O_{3,} magnetron sputtering is used to deposit a GZO thin film 20b having a thickness of 30 nm.

The surface of the back electrode layer 20 on the opposite side from the substrate 13b preferably has an appropriate textured structure. The textured structure of the surface of the back electrode layer 20 can be formed by controlling the deposition conditions for the Ag thin film, and mainly the deposition temperature and the deposition rate. For example, increasing the deposition temperature for the Ag thin film increases the Ag crystal particle size, forming asperity on the surface of the back electrode layer 20. The textured structure formed on the surface of the back electrode layer 20 preferably exhibits asperity in which the height and pitch are within a range from approximately 0.3 µm to 1 µm, which represents an appropriate size for achieving light confinement within the microcrystalline silicon.

The back electrode layer 20 may also have a structure comprising an impurity-doped low-resistance semiconductor layer, a metal thin film and an impurity-doped low-resistance semiconductor layer. For example, the back electrode layer 20 may be performed by depositing, in sequence from the substrate side, a GZO thin film, an Ag thin film, and a GZO thin film. In this case, the substrate-side GZO film is deposited first, and the surface of the GZO thin film is then subjected to an etching treatment in the same manner as that described for the transparent electrode layer 14 of the upper photovoltaic cell, thus forming asperity on the surface. The Ag thin film and the other GZO thin film are then deposited sequentially on the textured surface of the GZO thin film. This process results in the formation of a back electrode layer 20 having an appropriate texture on the surface.

Next, a plasma-enhanced chemical vapor deposition method is used to form the microcrystalline silicon photovoltaic layer 19 at a substrate temperature of 180°C. The microcrystalline silicon photovoltaic layer 19 is formed by sequentially depositing an n-type microcrystalline silicon layer 19c having a thickness of 30 nm, an i-type (undoped) microcrystalline silicon layer 19b having a thickness of 1,500 nm, and a p-type microcrystalline silicon layer 19a having a thickness of 30 nm.

Subsequently, the conductive thin-film layer 16b is deposited on the microcrystalline silicon photovoltaic layer 19. The conductive thin-film layer 16b is an impurity-doped low-resistance semiconductor layer, and is formed in the same manner as the conductive thin-film layer 16a of the upper photovoltaic cell 11.

### (Bonding of Upper Photovoltaic Cell and Lower Photovoltaic Cell)

The upper photovoltaic cell 11 and the lower photovoltaic cell 12 are bonded together via the anisotropic conductive adhesive layer 23.

In the present embodiment, the anisotropic conductive adhesive layer 23 is a sheet prepared by curing a material containing conductive microparticles 18 dispersed in a transparent insulating material 17. The same materials as those used in the first embodiment may be selected as the transparent insulating material and the conductive microparticles. The thickness of the anisotropic conductive adhesive layer 23 is 16 µm. The transparent insulating material 17 uses an adhesive comprising mainly an epoxy resin. The conductive microparticles 18 are styrene particles coated with a thin film of Au/Ni, and have a particle size of 4 µm. An appropriate technique such as plating may be employed for forming the coating. The amount of the conductive microparticles 18 incorporated within the transparent insulating material 17 is preferably not more than 30% by weight. This ensures an appropriate amount of light for use within the lower photovoltaic cell 12.

The anisotropic conductive adhesive layer 23 exhibits light transmittance of at least 80%, and preferably 95% or more, for the absorption wavelength region that is used effectively by the lower photovoltaic cell 12 for power generation, which in this embodiment is the wavelength region of 550 nm and greater.

The refractive index of the anisotropic conductive adhesive layer 23 is typically not less than 1.2 and not more than 2.0, and is preferably not less than 1.2 and not more than 1.6.

The upper photovoltaic cell 11 and the lower photovoltaic cell 12 are positioned so that the conductive thin-film layer 16a and the conductive thin-film layer 16b face each other. The sheet of the anisotropic conductive adhesive layer 23 is then inserted between the upper photovoltaic cell 11 and the lower photovoltaic cell 12.
The stacked structure of the upper photovoltaic cell 11, the anisotropic conductive adhesive layer 23 and the lower photovoltaic cell 12 stacked in this manner is heated to 70°C, and a pressure of 1 MPa is then applied for 3 seconds in the stacking direction to achieve preliminary bonding.

Following preliminary bonding, the upper photovoltaic cell 11 / anisotropic conductive adhesive layer 23 /lower photovoltaic cell 12 structure is heated to 190°C, and under a reduced pressure atmosphere, a pressure of 1 MPa to 4 MPa is applied for 20 seconds to effect final bonding and complete formation of the multi-junction photovoltaic device 10. In the multi-junction photovoltaic device 10 according to the present embodiment, the electric power generated within each of the photovoltaic cells is extracted using the transparent electrode layer 14 and the back electrode layer 20.

In the present embodiment, an ITO thin film is used as the impurity-doped low-resistance semiconductor layer, but any material may be used that is capable of achieving conductive bonding of the photovoltaic layers of the photovoltaic cells, namely the combination of the amorphous silicon photovoltaic layer 15 and the microcrystalline silicon photovoltaic layer 19, and the material is not necessarily limited to a conductive oxide.

According to the present embodiment, the problem that can occur in conventional methods in which each of the layers are stacked sequentially on a single substrate, wherein during formation of the thin films that constitute the second photovoltaic cell, mutual diffusion of the dopants between the bonded portions of the n-layer of the first photovoltaic cell and the p-layer of the second photovoltaic cell causes a deterioration in performance, can be effectively resolved.

The correlations between the embodiment illustrated in Fig. 3 and the basic structure illustrated in Fig. 1 are as described below.
The transparent electrode layer 14 of Fig. 3 corresponds with an electrode of Fig. 1. The p-type amorphous silicon layer 15a, the i-type amorphous silicon layer 15b and the n-type amorphous silicon layer 15c of Fig. 3 correspond with the pn layer 2 of Fig. 1. The conductive thin-film layer 16a of Fig. 3 corresponds with the low-resistance semiconductor layer 5a of Fig. 1. The anisotropic conductive adhesive layer 23 of Fig. 3 corresponds with the anisotropic conductive adhesive layer 6a of Fig. 1. The conductive thin-film layer b of Fig. 3 corresponds with the impurity-doped low-resistance semiconductor layer 5b of Fig. 1.
The p-type microcrystalline silicon layer 19a, the i-type microcrystalline silicon layer 19b and the n-type microcrystalline silicon layer 19c of Fig. 3 correspond with the pn layer 3 of Fig. 1.
The fifth to seventh embodiments illustrated in Fig. 4 to Fig. 6 also exhibit similar correlations to those described above.

Further, the upper photovoltaic cell 11 and the lower photovoltaic cell 12 are not limited to the superstrate-type hydrogenated amorphous silicon thin-film solar cell element and the substrate-type microcrystalline silicon solar cell element described above. The upper photovoltaic cell 11 and the lower photovoltaic cell 12 may be respectively formed from a superstrate-type solar cell element and a substrate-type solar cell element comprising mainly other forms of silicon, germanium, a silicon germanium-based group IV compound, a group III-V compound, a group II-VI compound, or a group I-III-VI compound.
Further, the pin structure of the upper photovoltaic cell and the lower photovoltaic cell may adopt a pn structure, or a nip structure or np structure in which the order of the p-type semiconductor layer and the n-type semiconductor layer is reversed.
Furthermore, the upper photovoltaic cell 11 and the lower photovoltaic cell 12 need not necessarily be thin-film solar cell elements, and solar cells that use bulk semiconductors of silicon, germanium, a silicon germanium-based group IV compound or a group III-V compound may also be used.

### [Third Embodiment]

A multi-junction photovoltaic device according to the third embodiment has the same structure as the first embodiment, and differs only in terms of the method used for forming the anisotropic conductive adhesive layer.
In the present embodiment, the anisotropic conductive adhesive layer is formed using a polymer adhesive containing dispersed conductive microparticles of the type that is used in liquid crystal displays and semiconductor mounting and the like. The polymer adhesive containing dispersed conductive microparticles comprises conductive microparticles dispersed within a transparent insulating material, and exhibits good fluidity. The same transparent insulating material and conductive microparticles as those used in the first embodiment may be selected. For example, a material prepared by dispersing, within an epoxy adhesive, conductive microparticles comprising styrene particles coated with a metal such as gold/nickel and having a particle size of 4 µm may be used as the polymer adhesive containing dispersed conductive microparticles. The light transmittance and refractive index of this anisotropic conductive adhesive layer may be the same as those described for the first embodiment.

In the present embodiment, the upper photovoltaic cell and the lower photovoltaic cell are bonded using the sequence described below.
First, the polymer adhesive containing the dispersed conductive microparticles is applied to the conductive thin-film layer of the upper photovoltaic cell to form an anisotropic conductive adhesive layer having a thickness of 16 µm.
Next, the lower photovoltaic cell is positioned on the anisotropic conductive adhesive layer so that the conductive thin-film layer of the lower photovoltaic cell contacts the anisotropic conductive adhesive layer. The lower photovoltaic cell is preferably positioned prior to curing of the polymer adhesive containing the dispersed conductive microparticles.

The stacked structure of the upper photovoltaic cell, the anisotropic conductive adhesive layer and the lower photovoltaic cell stacked in this manner is heated to 180°C, and a pressure of 1 MPa is then applied in a direction that pushes the upper photovoltaic cell and the lower photovoltaic cell together to effect final bonding and complete formation of the multi-junction photovoltaic device.
According to this embodiment, by using the polymer adhesive containing dispersed conductive microparticles, the upper photovoltaic cell and the lower photovoltaic cell can be bonded together using a smaller compression force than that required when the bonding is performed using an anisotropic conductive adhesive sheet prepared by curing a transparent insulating material containing conductive microparticles.

### [Fourth Embodiment]

A multi-junction photovoltaic device according to the fourth embodiment has the same structure as the first embodiment, and differs only in terms of the method used for forming the anisotropic conductive adhesive layer.
In the present embodiment, the anisotropic conductive adhesive layer is formed using mixed particles containing polymer microparticles and conductive microparticles.

The polymer microparticles are particles of a transparent insulating material. These polymer microparticles undergo cross-linking upon heating, and can fuse with other members. Examples of the material for the polymer microparticles include polystyrene, acrylic resins, ethylene-vinyl acetate copolymer (EVA) or polyvinyl alcohol (PVA) having thermal adhesive properties, and mixtures of the above materials.

The conductive microparticles exhibit conductivity and elasticity. Examples of materials that may be used as the conductive microparticles include materials prepared by coating polystyrene or an acrylic resin with a metal thin film of gold or nickel or the like.
In the present embodiment, the size of the mixed microparticles is selected so that light of short wavelengths is effectively reflected, whereas light of long wavelengths is transmitted. The size of the mixed microparticles is preferably not less than 0.1 µm and not more than 1 µm. In this embodiment, the size of the mixed microparticles is 0.7 µm.
The mixing ratio between the polymer microparticles and the conductive microparticles is selected appropriately to ensure an appropriate amount of light for use within the lower photovoltaic cell.

In the present embodiment, the upper photovoltaic cell and the lower photovoltaic cell are bonded using the sequence described below.
First, an appropriate amount of the mixed microparticles is scattered on the conductive thin-film layer of the upper photovoltaic cell. Here, an "appropriate amount" describes an amount which, upon formation of the anisotropic conductive adhesive layer, yields satisfactory conductivity in the thickness direction and satisfactory insulating properties in the in-plane direction. Next, the lower photovoltaic cell is positioned so that the conductive thin-film layer of the lower photovoltaic cell contacts the scattered mixed microparticles.

The stacked structure of the upper photovoltaic cell, the anisotropic conductive adhesive layer and the lower photovoltaic cell stacked in this manner is heated to 90°C, and a pressure of 1 MPa is then applied in a direction that pushes the upper photovoltaic cell and the lower photovoltaic cell together to achieve preliminary bonding.
Following preliminary bonding, the upper photovoltaic cell / anisotropic conductive adhesive layer /lower photovoltaic cell structure is heated to 190°C, and a pressure of 3 MPa is applied to effect final bonding and complete formation of the multi-junction photovoltaic device. During this process, voids may exist between the microparticles within the anisotropic conductive adhesive layer.

According to the present embodiment, the anisotropic conductive adhesive layer can be formed as a thinner layer than that obtainable using an anisotropic conductive adhesive sheet or a polymer adhesive containing dispersed conductive microparticles. Because the conductive microparticles exhibit elasticity, the load placed on the upper photovoltaic cell and the lower photovoltaic cell by the conductive microparticles during bonding can be reduced. Further, because voids exist between the microparticles within the anisotropic conductive adhesive layer, an anisotropic conductive adhesive layer having superior light transmittance and a low refractive index can be obtained.

### [Fifth Embodiment]

A multi-junction photovoltaic device according to the fifth embodiment has the same structure as the first embodiment with the exception of the conductive thin-film layers. Fig. 4 is a schematic view illustrating the structure of a multi-junction photovoltaic device 20 according to the fifth embodiment.
In this embodiment, the conductive thin-film layers 26 each have a two-layer structure comprising an impurity-doped low-resistance semiconductor layer 16 and a grid electrode layer 22.

First, an ITO thin film is deposited on the amorphous silicon photovoltaic layer 15 as an impurity-doped low-resistance semiconductor layer 16a, in the same manner as the first embodiment.
An Ag grid electrode layer 22a having a width of 100 µm is then deposited on the impurity-doped low-resistance semiconductor layer 16a by magnetron sputtering with no heating. The material for the grid electrode layer 22a is not limited to Ag, and other metals may also be used.

The conductive thin-film layer 16b of the lower photovoltaic cell 12 is formed in a similar manner to that described for the upper photovoltaic cell 11, and is formed on top of the microcrystalline silicon photovoltaic layer 19.
The upper photovoltaic cell 11 and the lower photovoltaic cell 12 are then positioned so that the grid electrode layer 22a and the grid electrode layer 22b are superimposed in the stacking direction, and bonding via an anisotropic conductive adhesive layer is then performed using the same method as that described for any one of the second to the fourth embodiments.

### [Sixth Embodiment]

In a multi-junction photovoltaic device according to the sixth embodiment, the lower photovoltaic cell has a photovoltaic layer with a two-layer structure. The structure of a photovoltaic device 30 according to the sixth embodiment is illustrated in Fig. 5.

### (Upper Photovoltaic Cell)

A transparent electrode layer 34 is deposited on a highly transparent substrate 33a to form a transparent electrode film-bearing substrate. In the present embodiment, a U substrate (thickness: 1.1 mm, SiO₂) manufactured by Asahi Glass Co., Ltd. (AGC) is used as the transparent electrode film-bearing substrate. A texture having appropriate asperity is formed on the surface of the transparent electrode film on the opposite side from the substrate. This asperity is of sub-micron size with a height and pitch of not less than 0.1 µm and not more than 0.3 µm. In those cases where the substrate 33a is a glass sheet, a substrate in which, in addition to the transparent electrode layer 14, an alkali barrier film (not shown in the drawing) is provided between the glass sheet and the transparent electrode film, may also be used.

Using a plasma-enhanced CVD apparatus, under conditions including a reduced pressure atmosphere of not less than 30 Pa and not more than 300 Pa, and a substrate temperature of approximately 200°C, a photovoltaic layer 35 of an upper photovoltaic cell 31 is formed by sequentially depositing a p-layer 35a, an i-layer 35b and an n-layer 35c, each composed of a thin film of amorphous silicon, on the transparent electrode layer 34, with the p-layer 35a closest to the surface from which incident sunlight enters.

In the present embodiment, the p-layer 35a of the photovoltaic layer 35 of the upper photovoltaic cell 31 is an amorphous B-doped SiC film produced by reaction in a high-frequency plasma using SiH₄, H₂ and CH₄ as the main raw materials and using B₂H₆ as a dopant gas. The thickness of the p-layer 35a is preferably not less than 4 nm and not more than 10 nm.

The i-layer 35b of the photovoltaic layer 35 of the upper photovoltaic cell 31 is an amorphous Si layer produced by reaction of SiH₄ and H₂ gas in a high-frequency plasma. The thickness of the i-layer 35b is preferably not less than 100 nm and not more than 250 nm.

The n-layer 35c of the photovoltaic layer 35 of the upper photovoltaic cell 31 may be a Si film containing crystalline components produced by reaction in a high-frequency plasma using SiH₄ and H₂ as the main raw materials and using PH₃ as a dopant gas. When a single film of the n-layer 35c is measured by Raman spectroscopy, the ratio of the intensity of a Si crystalline component peak at 520 cm² relative to the intensity of an amorphous silicon component peak at 480 cm² (hereinafter referred to as the "Raman ratio") is not less than 2. The thickness of the n-layer 35c is preferably not less than 10 nm and not more than 80 nm. Further, a buffer layer (not shown in the drawing) may be provided between the p-layer 35a and the i-layer 35b to improve the interface properties.

Moreover, in order to form a favorable ohmic contact between the anisotropic conductive adhesive layer 23 and the photovoltaic layer 35, a conductive thin-film layer 36a is formed on the photovoltaic layer 35 of the upper photovoltaic cell 31. The conductive thin-film layer 36a is an ITO thin film having a thickness of not less than 50 nm and not more than 200 nm. The conductive thin-film layer 36a is deposited by magnetron sputtering, under conditions including a reduced pressure atmosphere of not more than 5 Pa and a substrate temperature of approximately 200°C. The conductive thin-film layer 36a may also employ a Ga- or Al-doped ZnO thin film instead of the ITO thin film.

### (Lower Photovoltaic Cell)

A back electrode layer 40 is formed on a substrate 33b. In the present embodiment, the back electrode layer 40 comprises a conductive oxide film 40a, a metal electrode film 40b and a conductive oxide film 40c.
The conductive oxide film 40a is formed by depositing a thin film of ZnO (Ga- or Al-doped ZnO) using a sputtering apparatus under a reduced pressure atmosphere at a temperature of approximately 150°C. The amount of Ga or Al doping may be set as appropriate. In the present embodiment, a ZnO film doped with 4% by weight of Al and having a thickness of 2 µm is deposited. Subsequently, the conductive oxide film 40a is etched using either hydrochloric acid or a plasma, yielding a film with an average thickness of 1 µm and having surface asperity in which the pitch and height are both approximately 1 µn.
The metal electrode film 40b is an Ag film having a thickness of 100 nm, which is deposited using a sputtering apparatus under a reduced pressure atmosphere with no heating.
A ZnO film doped with 4% by weight of Al and having a thickness of 30 nm is then deposited on the metal electrode film 40b as the conductive oxide film 40c.

Next, photovoltaic layers are formed on the back electrode layer 40. In the present embodiment, these photovoltaic layers are composed of a second photovoltaic layer 41 comprising an i-layer 41b containing mainly microcrystalline silicon germanium (SiGe), and a first photovoltaic layer 39 comprising an i-layer 39b containing mainly microcrystalline Si.

First, using a plasma-enhanced CVD apparatus, and under conditions including a reduced pressure atmosphere of not more than 3,000 Pa, a substrate temperature of approximately 200°C and a plasma generation frequency of not less than 40 MHz and not more than 100 MHz, an n-layer 41c composed of microcrystalline Si, an i-layer 41b composed of microcrystalline silicon germanium (SiGe) and a p-layer 41a composed of microcrystalline Si are stacked sequentially as the second photovoltaic layer 41 on top of the back electrode layer 40. The order of stacking is the reverse of that in the upper photovoltaic cell.

In the present embodiment, the n-layer 41c of the second photovoltaic layer 41 is a Si film containing crystalline components produced by reaction in a high-frequency plasma using SiH₄ and H₂ as the main raw materials and using PH₃ as a dopant gas. The n-layer 41c has a Raman ratio as a single film of not less than 2. The thickness of the n-layer 41c is preferably not less than 10 nm and not more than 80 nm.

The i-layer 41b of the second photovoltaic layer 41 is an SiGe film containing crystalline components produced by reaction in a high-frequency plasma using SiH₄, GeH₄ and H₂ gas as the main raw materials. The thickness of the i-layer 41b is preferably not less than 500 nm and not more than 2,000 nm. Further, the Ge atomic composition ratio within the i-layer is preferably not less than 5% and not more than 50%.

The p-layer 41a of the second photovoltaic layer 41 is a Si film containing crystalline components produced by reaction in a high-frequency plasma using SiH₄ and H₂ as the main raw materials and using B₂H₆ as a dopant gas. The p-layer 41a has a Raman ratio as a single film of not less than 2. The thickness of the p-layer 41a is preferably not less than 10 nm and not more than 60 nm.

Further, a composition adjustment layer (not shown in the drawing) may be provided between the n-layer and the i-layer, or between the i-layer and the n-layer in order to improve the interface properties. In the composition adjustment layer, the Ge composition ratio gradually changes from the composition ratio within the actual i-layer, to a value of 0 at the interface with the n-layer or the p-layer.

Subsequently, using a plasma-enhanced CVD apparatus, and under conditions including a reduced pressure atmosphere of not more than 3,000 Pa, a substrate temperature of approximately 200°C and a plasma generation frequency of not less than 40 MHz and not more than 100 MHz, an n-layer 39c, an i-layer 39b and a p-layer 39a, each composed of microcrystalline Si, are stacked sequentially as the first photovoltaic layer 39 of the lower photovoltaic cell on top of the second photovoltaic layer 41 of the lower photovoltaic cell.

In the present embodiment, the n-layer 39c and the p-layer 39a of the first photovoltaic layer 39 of the lower photovoltaic cell are deposited using high-frequency plasma-enhanced CVD under the same conditions as the second photovoltaic layer of the lower photovoltaic cell. The i-layer 39b of the first photovoltaic layer 39 is a Si film containing crystalline components produced by reaction in a high-frequency plasma using SiH₂ and H₂ gas. The thickness of the i-layer 39b is preferably not less than 500 nm and not more than 2,000 nm.

A transparent layer having a low refractive index of not more than 2, a light transmittance of at least 90% for wavelengths of 600 nm or longer, and a level of conductivity that has no effect on the series resistance of the cell may be inserted between the first photovoltaic layer 39 and the second photovoltaic layer 41 of the lower photovoltaic cell in order to regulate the flow of generated electric current within the first photovoltaic layer 39 and the second photovoltaic layer 41.

Moreover, in order to form a favorable ohmic contact between the anisotropic conductive adhesive layer 23 and the photovoltaic layer 39, a conductive thin-film layer 36b is formed on the photovoltaic layer 39 of the lower photovoltaic cell 32, in a similar manner to that described for the upper photovoltaic cell 31.
The upper photovoltaic cell 31 and the lower photovoltaic cell 32 are connected electrically in series via the anisotropic conductive adhesive layer 23, thus forming a multi-junction photovoltaic cell.

### (Bonding of Upper Photovoltaic Cell and Lower Photovoltaic Cell)

The upper photovoltaic cell 31 and the lower photovoltaic cell 32 are bonded together via an anisotropic conductive adhesive layer, using the same method as that described for any one of the second to the fourth embodiments.

In the present embodiment, the photovoltaic layer of the lower photovoltaic cell 31 has been described as a two-layer structure, but the photovoltaic layer of the upper photovoltaic cell 31 may also have a plurality of layers. Generally, the optimal deposition conditions differ for an amorphous silicon photovoltaic layer and a microcrystalline silicon photovoltaic layer. Accordingly, in those cases where a plurality of photovoltaic layers are stacked within a single photovoltaic cell, the plurality of photovoltaic layers are preferably selected from materials having a common crystalline (amorphous) state. For example, the upper photovoltaic cell 31 may be formed as a multi-junction photovoltaic cell having, in sequence from the light-incident side of the cell, a photovoltaic layer comprising an i-layer containing mainly amorphous Si, and a separate photovoltaic layer comprising an i-layer containing mainly amorphous SiGe.

### [Seventh Embodiment]

In the seventh embodiment, an integrated hydrogenated amorphous silicon thin-film solar cell is used as an upper power generation module, and an integrated microcrystalline silicon solar cell is used as a lower power generation module. Fig. 6 is a schematic view illustrating the structure of an integrated multi-junction photovoltaic device 40 according to the seventh embodiment. In this embodiment, the upper power generation module and the lower power generation module are connected electrically via an anisotropic conductive adhesive layer, using the same method as that described for any one of the second to the fourth embodiments.

A process for producing the integrated multi-junction Photovoltaic device 50 is described below with reference to Fig. 7.

### (Upper Power Generation Module)

In this embodiment, a substrate 53a uses a soda float glass substrate (for example with dimensions of 1.4 m × 1.1 m × thickness: 3.0 mm) as a large substrate having a surface area exceeding 1 m². The edges of the substrate are preferably subjected to corner chamfering or R-face chamfering to prevent damage caused by thermal stress or impacts or the like.

A transparent electrode film comprising mainly tin oxide (SnO₂) and having a film thickness of approximately 500 nm to 800 nm is deposited as a transparent electrode layer 54, using a thermal CVD apparatus at a temperature of approximately 500°C. During this deposition, a texture comprising suitable asperity is formed on the surface of the transparent conductive film. In the present embodiment, this asperity (not shown in the drawing) is of a sub-micron size in which the height and pitch are both approximately 0.1 µm to 0.3 µm. In addition to the transparent electrode film, the transparent electrode layer 54 may also include an alkali barrier film (not shown in the drawing) formed between the substrate 53a and the transparent electrode film. The alkali barrier film is formed using a thermal CVD apparatus at a temperature of approximately 500°C to deposit a silicon oxide film (SiO₂) having a film thickness of 50 nm to 150 nm.

Subsequently, the substrate 53a is mounted on an X-Y table, and the first harmonic of a YAG laser (1064 nm) is irradiated onto the surface of the transparent electrode film 54 on the opposite side from the substrate 53a (arrow A). The laser power is adjusted to ensure an appropriate process speed, and the transparent electrode film is then moved in a direction perpendicular to the direction of the series connection of the upper photovoltaic cell, thereby causing a relative movement between the substrate 53a and the laser light, and conducting laser etching across a strip having a predetermined width of approximately 6 mm to 15 mm to form a first slot 110a.

Using a plasma-enhanced CVD apparatus, and under conditions including a reduced pressure atmosphere of 30 Pa to 1,000 Pa and a substrate temperature of approximately 200°C, a p-layer, an i-layer and an n-layer, each composed of a thin film of amorphous silicon, are deposited sequentially as a photovoltaic layer 55. The photovoltaic layer 55 is deposited on the transparent electrode layer 54 using SiH₄ gas and H₂ gas as the main raw materials. The p-layer, the i-layer and the n-layer are deposited, in that order, with the p-layer closest to the surface from which incident sunlight enters. In the present embodiment, the photovoltaic layer 55 is composed of a p-layer comprising mainly B-doped amorphous SiC and having a thickness of 10 nm to 30 nm, an i-layer comprising mainly amorphous Si and having a thickness of 200 nm to 350 nm, and an n-layer comprising mainly P-doped silicon in which microcrystalline Si is incorporated within amorphous Si, having a thickness of 30 nm to 50 nm. A buffer layer may be provided between the p-layer and i-layer in order to improve the interface properties.

The substrate 53a is mounted on an X-Y table, and the second harmonic of a laser diode excited YAG laser (532 nm) is irradiated onto the film surface of the photovoltaic layer 55, as shown by arrow B in Fig. 7. With the pulse oscillation set to 10 kHz to 20 kHz, the laser power is adjusted so as to achieve a suitable process speed, and laser etching is conducted at a point approximately 100 µn to 150 µm to the side of the laser etching line within the transparent electrode layer 54, so as to form a second slot 111a. The laser may also be irradiated from the side of the substrate 53a, and in this case, because the high vapor pressure generated by the energy absorbed by the amorphous silicon layer of the photovoltaic layer 55 can be utilized in etching the photovoltaic layer 55, more stable laser etching processing can be performed. The position of the laser etching line is determined with due consideration of positioning tolerances, so as not to overlap with the previously formed etching line.
As a result of this etching process, adjacent sections of the photovoltaic layer 55 are electrically isolated while retaining the underlying transparent electrode layer 54.

A GZO film having a thickness of 30 nm to 100 nm is deposited as a conductive thin-film layer 56a on top of the photovoltaic layer 55, using a sputtering apparatus and a substrate temperature of approximately 150°C.

The substrate 53 is mounted on an X-Y table, and the second harmonic of a laser diode excited YAG laser (532 nm) is irradiated through the substrate 53a, as shown by arrow C in Fig. 7. The laser light is absorbed by the photovoltaic layer 55, and by utilizing the high gas vapor pressure generated at this point, the conductive thin-film layer 56a is removed by explosive fracture. With the pulse oscillation set to 1 kHz to 50 kHz, the laser power is adjusted so as to achieve a suitable process speed, and laser etching is conducted at a point approximately 250 µm to 400 µm to the side of the laser etching line within the transparent electrode layer 54, so as to form a third slot 112a. This slot formation isolates adjacent sections of the photovoltaic layer 55 and the conductive thin-film layer 56a.

Further, laser etching (arrow D) is then performed to remove the photovoltaic layer 55 formed inside the first slot 110a and the conductive thin-film layer 56a formed thereon, thus forming a fourth slot 115a. By superimposing the fourth slot in the same position where the first slot was formed, any unnecessary reduction in the area of the power generation region can be prevented. The fourth slot 115a need not necessarily be formed in the same position as the first slot 110a.
Although the laser light used in the steps until this point has been specified as YAG laser light, light from a YVO4 laser or fiber laser or the like may also be used in a similar manner.

### (Lower Power Generation Module)

In a similar manner to the upper photovoltaic cell 51, a soda float glass substrate 53b is used.
A back electrode layer 60 is formed on the substrate 53b. In the present embodiment, the back electrode layer 60 comprises, in sequence from the side of the substrate 53, a conductive oxide film 60a, a metal electrode film 60b and a conductive oxide film 60c.
The conductive oxide film 60a is formed, for example, by depositing a ZnO (Ga- or Al-doped ZnO) film using a sputtering apparatus under a reduced pressure atmosphere at a temperature of approximately 150°C. The amount of Ga or Al doping may be set as appropriate. In the present embodiment, a ZnO film doped with 4% by weight of Al and having a thickness of 2 µm is deposited. Subsequently, the conductive oxide film 60a is etched using either hydrochloric acid or a plasma, yielding a film with an average thickness of 1 µm and having surface asperity in which the pitch and height are both at the sub-micron level. In Fig. 6 and Fig. 7, the asperity of each of the layers is omitted in order to make the layer structure within each of the photovoltaic modules easier to understand.
The metal electrode film 60b is an Ag film having a thickness of 100 nm, which is deposited using a sputtering apparatus under a reduced pressure atmosphere with no heating.
A ZnO film doped with 4% by weight of Al and having a thickness of 30 nm is then deposited on the metal electrode film 60b as the conductive oxide film 60c.

Subsequently, the substrate 53b is mounted on an X-Y table, and the second harmonic of a YAG laser (532 nm) is irradiated onto the surface of the back electrode layer 60. The laser power is adjusted to ensure an appropriate process speed, and the back electrode layer 60 is then moved in a direction perpendicular to the direction of the series connection of the lower photovoltaic cell, thereby causing a relative movement between the substrate 53b and the laser light, and conducting laser etching across a strip having a predetermined width of approximately 6 mm to 15 mm to form a first slot 110b. This isolates adjacent sections of the back electrode layer 60.

Next, using a plasma-enhanced CVD apparatus, and under conditions including a reduced pressure atmosphere of not more than 3,000 Pa, a substrate temperature of approximately 200°C and a plasma generation frequency of 40 MHz to 100 MHz, a microcrystalline n-layer, a microcrystalline i-layer and a microcrystalline p-layer, each composed of a thin film of microcrystalline silicon, are deposited sequentially as a photovoltaic layer 59 on top of the back electrode layer 60.
In the present embodiment, the photovoltaic layer 59 is composed of a microcrystalline n-layer comprising mainly P-doped microcrystalline Si and having a thickness of 20 nm to 50 nm, a microcrystalline i-layer comprising mainly microcrystalline Si and having a thickness of 1.2 µm to 3.0 µm, and a microcrystalline p-layer comprising mainly B-doped microcrystalline SiC and having a thickness of 10 nm to 50 nm. The microcrystalline n-layer may also be an amorphous n-layer.

During formation by plasma-enhanced CVD method of the microcrystalline silicon thin films, and particularly the microcrystalline i-layer, a distance d between the plasma discharge electrode and the surface of the substrate 53b is preferably set to 3 mm to 10 mm. If this distance d is less than 3 mm, then the precision of the various structural components within the film deposition chamber required for processing large substrates 53 means that maintaining the distance d at a constant value becomes difficult, which increases the possibility of the electrode getting too close and making the discharge unstable. If the distance d exceeds 10 mm, then achieving a satisfactory deposition rate (of at least 1 nm/s) becomes difficult, and the uniformity of the plasma also deteriorates, causing a deterioration in the quality of the film due to ion impact.

The deposited photovoltaic layer 59 is subjected to laser etching processing in the same manner as that described for the upper photovoltaic cell. In a similar manner to the upper photovoltaic cell, etching processing is also performed after deposition of a conductive thin-film layer 56b on the photovoltaic layer 59.

### (Bonding of Upper Power Generation Module and Lower Power Generation Module)

The upper photovoltaic cell and the lower photovoltaic cell are positioned with the conductive thin-film layer 56a and the conductive thin-film layer 56b facing each other, and with the position of the fourth slot 115a within the upper power generation module aligned with the position of the third slot 112b within the lower power generation module. The upper photovoltaic cell and the lower photovoltaic cell are then bonded via an anisotropic conductive adhesive layer 23 using the same method as that described for any one of the second to the fourth embodiments.
In the case where the anisotropic conductive adhesive layer 23 is formed using a polymer adhesive containing dispersed conductive microparticles, in accordance with the third embodiment, etching processing may be performed after the formation of the anisotropic conductive adhesive layer on the conductive thin-film layer 56a.
In the present embodiment, the anisotropic conductive adhesive layer is formed using mixed microparticles composed of polymer microparticles and conductive microparticles. In the present embodiment, the particle size of the conductive microparticles 58 is smaller than the width of the laser scribed slots. This ensures that conduction across the laser scribed slots does not occur. For example, in the case where the mixed microparticles contain 30% by weight of the conductive microparticles, the particle size of the microparticles is preferably not more than 1/4 of the width of the laser scribed slots. This reduces the probability of microparticles interlinking to bridge a slot to 1% or less.

In the integrated multi-junction photovoltaic device 50 produced in accordance with the present embodiment, within the upper photovoltaic module or the lower photovoltaic module, adjacent photovoltaic cells in the in-plane direction are electrically isolated from each other. Further, because the transparent insulating material 57 exists between adjacent conductive microparticles 58, the anisotropic conductive adhesive layer 23 has insulating properties in the in-plane direction. However, the anisotropic conductive adhesive layer 23 exhibits conductivity in the thickness direction, and therefore an electrical connection between the conductive thin-film layer 56a and the conductive thin-film layer 56, and an electrical connection between the transparent electrode layer 54 and the back electrode layer 60 can both be achieved simultaneously. In other words, each of the adjacent multi-junction solar cells are connected electrically in series. Further, output from the substrate can be extracted via the transparent electrode layer 54 and the back electrode layer 60.

Furthermore, Fig. 7 illustrates a case where, because the mutually facing conductive thin-film layer 56a and conductive thin-film layer 56b exhibit a resistance in the lateral direction (in-plane direction) that is not significantly different from that of the transparent electrode layer 54, the fourth slots 115 are provided within the upper photovoltaic module 51 and the lower photovoltaic module 52, but in those cases where an impurity-doped semiconductor layer or a grid electrode layer having a significantly higher resistance in the lateral direction (in-plane direction) than the conductive thin-film layer 56 is used, the fourth slots 115 need not necessarily be provided in the upper photovoltaic module 51 and the lower photovoltaic module 52.

It should be self-evident that the present invention may also be employed in silicon-based thin-film solar cells where the order of the pin structures within the examples described above is reversed, in other silicon, germanium or silicon germanium-based group IV solar cells, or in group I-III-VI compound, group III-V compound or group II-VI compound solar cells.
Furthermore, it should also be self-evident that the present invention may also be employed in silicon, germanium or silicon germanium-based group IV solar cells, or group I-III-VI compound, group III-V compound or group II-VI compound solar cells, in which a grid electrode layer is used instead of an impurity-doped low-resistance semiconductor layer as the outermost layer that connects each of the integrated solar cells.

### {Industrial Applicability}

The present invention provides a novel device in which different semiconductors having different electrical and optical functions are bonded together with a transparent insulating material containing conductive microparticles, thus yielding a device combining the functions of each of the semiconductors. For example, by bonding together photovoltaic layers having different spectral sensitivity levels via a transparent insulating material containing conductive microparticles, a high-efficiency multi-junction photovoltaic device and an integrated multi-junction photovoltaic device that exhibit sensitivity across a broad wavelength region can be produced.

### {Reference Signs List}

1, 10, 20, 30, 50 Multi-junction photovoltaic device
2, 3, 4 Photovoltaic cell
5, 16, 26, 36 Conductive thin-film layer
6, 23 Anisotropic conductive adhesive layer
11, 31 Upper photovoltaic cell
12, 32 Lower photovoltaic cell
13, 33, 53 Substrate
14, 34, 54 Transparent electrode layer
15, 35, 55 Amorphous silicon photovoltaic layer
17, 57 Transparent insulating material
18, 58 Conductive microparticles
19, 39, 59 Microcrystalline silicon photovoltaic layer
20, 40, 60 Back electrode layer
41 Microcrystalline silicon germanium photovoltaic layer
51 Upper photovoltaic module
52 Lower photovoltaic module
110 First slot
111 Second slot
112 Third slot
115 Fourth slot

## Claims

1. A multi-junction photovoltaic device prepared by stacking, and optically and electrically connecting, a plurality of photovoltaic cells having different spectral sensitivity levels, wherein
at least photovoltaic cells at a light-incident end and an opposite end have a conductive thin-film layer as an outermost layer on a side that undergoes connection, remaining photovoltaic cells have conductive thin-film layers as outermost layers on both sides that undergo connection, and the outermost layers are bonded via an anisotropic conductive adhesive layer comprising conductive microparticles within a transparent insulating material.

2. The multi-junction photovoltaic device according claim 1, wherein a number of the photovoltaic cells is two.

3. A multi-junction photovoltaic device, comprising:
an upper photovoltaic cell having a transparent electrode layer, an upper photovoltaic layer and an upper conductive thin-film layer provided in that order on an upper transparent substrate,
a lower photovoltaic cell having a back electrode layer, a lower photovoltaic layer having a different spectral sensitivity from the upper photovoltaic layer, and a lower conductive thin-film layer provided in that order on a lower substrate, and
an anisotropic conductive adhesive layer comprising a transparent insulating material having an adhesive function, and conductive microparticles dispersed within the transparent insulating material, wherein
the upper conductive thin-film layer is positioned adjacent to one surface of the anisotropic conductive adhesive layer,
the lower conductive thin-film layer is positioned adjacent to another surface of the anisotropic conductive adhesive layer, and
the upper photovoltaic cell and the lower photovoltaic cell are connected electrically in series via the anisotropic conductive adhesive layer.

4. The multi-junction photovoltaic device according to claim 3, wherein the anisotropic conductive adhesive layer exhibits a light transmittance of at least 80% for light of a wavelength region absorbed mainly by the lower photovoltaic layer.

5. The multi-junction photovoltaic device according to claim 3 or claim 4, wherein a refractive index of the anisotropic conductive adhesive layer is not less than 1.2 and not more than 2.0.

6. The multi-junction photovoltaic device according to any one of claims 3 to 5, wherein
the upper photovoltaic layer comprises mainly amorphous silicon,
the transparent electrode layer has a textured structure on a surface on an opposite side from the upper transparent substrate, and
the textured structure has asperity with a pitch and height of not less than 0.1 µm and not more than 0.3 um.

7. The multi-junction photovoltaic device according to any one of claims 3 to 6, wherein
the lower photovoltaic layer comprises mainly microcrystalline silicon,
the back electrode layer has a textured structure on a surface on an opposite side from the lower substrate, and
the textured structure has asperity with a pitch and height of not less than 0.3 µm and not more than 1 µm.

8. The multi-junction photovoltaic device according to any one of claims 1 to 7, wherein the conductive thin-film layer is at least one of an impurity-doped low-resistance semiconductor layer and a grid electrode layer.

9. The multi-junction photovoltaic device according to claim 8, wherein the impurity-doped low-resistance semiconductor layer is a transparent conductive layer.

10. An integrated multi-junction photovoltaic device prepared by stacking, and optically and electrically connecting two of the photovoltaic cells having different spectral sensitivity levels defined in any one of claims 1 to 9, wherein
each of the integrated photovoltaic devices has a conductive thin-film layer as a outermost layer on a side that undergoes connection, and the outermost layers, and electrodes on an opposite side that function as counter electrode to the outermost layers, are bonded via an anisotropic conductive adhesive layer comprising conductive microparticles within a transparent insulating material, thereby connecting adjacent multi-junction photovoltaic elements in series.

11. An integrated multi-junction photovoltaic device, comprising:
an upper photovoltaic module comprising integrated upper photovoltaic cells having a transparent electrode layer, and an upper power generation portion and an upper conductive portion disposed so as to be isolated from the upper power generation portion provided on top of the transparent electrode layer, and provided with an upper conductive thin-film layer positioned as an outermost surface layer on the upper power generation portion and the upper conductive portion,
a lower photovoltaic module comprising integrated lower photovoltaic cells having a back electrode layer, and a lower power generation portion having a different spectral sensitivity from the upper powder generation portion and a lower conductive portion disposed so as to be isolated from the lower power generation portion provided on top of the back electrode layer, and provided with a lower conductive thin-film layer positioned as an outermost surface layer on the lower power generation portion and the lower conductive portion, and
an anisotropic conductive adhesive layer comprising a transparent insulating material and conductive microparticles dispersed within the transparent insulating material, wherein
the upper conductive thin-film layer is positioned adjacent to one surface of the anisotropic conductive adhesive layer,
the lower conductive thin-film layer is positioned adjacent to another surface of the anisotropic conductive adhesive layer,
the upper power generation portion of a predetermined upper photovoltaic cell and the lower power generation portion of a predetermined lower photovoltaic cell are aligned, and the lower conductive portion of a predetermined lower photovoltaic cell is aligned with the upper conductive portion of an upper photovoltaic cell adjacent to a predetermined upper photovoltaic cell,
the aligned upper power generation portion and lower power generation portion are connected electrically in series via the anisotropic conductive adhesive layer, and
the aligned upper conductive portion and lower conductive portion are connected electrically via the anisotropic conductive adhesive layer.

12. A process for producing a multi-junction photovoltaic device, the process comprising:
a step of forming a first conductive thin-film layer on a first semiconductor,
a step of forming a second conductive thin-film layer on a second semiconductor, and
a step of inserting an anisotropic conductive adhesive layer comprising conductive microparticles within a transparent insulating material between the first conductive thin-film layer and the second conductive thin-film layer, and bonding a first integrated photovoltaic device and a second integrated photovoltaic device via the anisotropic conductive adhesive layer.

13. A process for producing a multi-junction photovoltaic device, the process comprising:
a step of forming an upper photovoltaic cell having a transparent electrode layer, an upper photovoltaic layer and an upper conductive thin-film layer provided in that order on an upper transparent substrate,
a step of forming a lower photovoltaic cell having a back electrode layer, a lower photovoltaic layer having a different spectral sensitivity from the upper photovoltaic layer, and a lower conductive thin-film layer provided in that order on a lower substrate,
a step of forming a stacked structure by positioning the upper photovoltaic cell, an anisotropic conductive adhesive layer comprising a transparent insulating material having an adhesive function, and conductive microparticles dispersed within the transparent insulating material, and the lower photovoltaic cell so that the upper conductive thin-film layer is positioned adjacent to one surface of the anisotropic conductive adhesive layer, and the lower conductive thin-film layer is positioned adjacent to another surface of the anisotropic conductive adhesive layer, and
a step of subjecting the stacked structure to thermocompression bonding to bond together the upper photovoltaic cell, the anisotropic conductive adhesive layer and the lower photovoltaic cell.

14. The process for producing a multi-junction photovoltaic device according to claim 13, wherein the anisotropic conductive adhesive layer is formed using any one of an anisotropic conductive adhesive sheet, a polymer adhesive containing dispersed metal particles, and mixed microparticles composed of polymer microparticles and conductive microparticles.

15. A process for producing an integrated multi-junction photovoltaic device, the process comprising:
a step of producing an upper photovoltaic module by integrating upper photovoltaic cells having a transparent electrode layer, an upper power generation portion and an upper conductive portion isolated from the upper power generation portion provided on top of the transparent electrode layer, and an upper conductive thin-film layer provided as an outermost surface layer on the upper power generation portion and the upper conductive portion,
a step of producing a lower photovoltaic module by integrating lower photovoltaic cells having a back electrode layer, a lower power generation portion having a different spectral sensitivity from the upper powder generation portion and a lower conductive portion isolated from the lower power generation portion provided on top of the back electrode layer, and a lower conductive thin-film layer provided as an outermost surface layer on the lower power generation portion and the lower conductive portion,
a step of forming a stacked structure by positioning the upper photovoltaic module, an anisotropic conductive adhesive layer comprising a transparent insulating material having an adhesive function, and conductive microparticles dispersed within the transparent insulating material, and the lower photovoltaic module so that the upper conductive thin-film layer is positioned adjacent to one surface of the anisotropic conductive adhesive layer, the lower conductive thin-film layer is positioned adjacent to another surface of the anisotropic conductive adhesive layer, the upper power generation portion of a predetermined upper photovoltaic cell and the lower power generation portion of a predetermined lower photovoltaic cell are aligned, and the lower conductive portion of a predetermined lower photovoltaic cell is aligned with the upper conductive portion of an upper photovoltaic cell adjacent to a predetermined upper photovoltaic cell, and
a step of subjecting the stacked structure to thermocompression bonding, thereby bonding together the upper photovoltaic cell, the anisotropic conductive adhesive layer and the lower photovoltaic cell, and the upper conductive portion, the anisotropic conductive adhesive layer and the lower conductive portion.
